**Europäisches Patentamt**

**(19) European Patent Office**

**Office européen des brevets**

(11) Publication number : **0 382 184 B1**

(12) **EUROPEAN PATENT SPECIFICATION**

(45) Date of publication of patent specification : **23.08.95 Bulletin 95/34**

(51) Int. Cl.⁶ : **G06F 11/26**

(21) Application number : **90102402.6**

(22) Date of filing : **07.02.90**

(54) **Circuit for testability.**

(30) Priority : **07.02.89 JP 26593/89**

(43) Date of publication of application : **16.08.90 Bulletin 90/33**

(45) Publication of the grant of the patent : **23.08.95 Bulletin 95/34**

(84) Designated Contracting States : **DE FR GB**

(56) References cited :
**EP-A- 0 292 116**
**US-A- 4 698 588**
**US-A- 4 766 593**

(73) Proprietor : **KABUSHIKI KAISHA TOSHIBA
72, Horikawa-cho,
Saiwai-ku
Kawasaki-shi, Kanagawa-ken 210, Tokyo (JP)**

(72) Inventor : **Yaguchi, Toshiyuki
3029-3-D107 Nogawa, Miyamae-ku
Kawasaki-shi, Kanagawa-ken (JP)**
Inventor : **Tanaka, Koichi
438 Imanimanicho,
Nakahara-ku
Kanagawa-ken (JP)**

(74) Representative : **Lehn, Werner, Dipl.-Ing. et al
Hoffmann, Eitle & Partner,
Patentanwälte,
Postfach 81 04 20
D-81904 München (DE)**

**Description**

CIRCUIT FOR TESTABILITY

BACKGROUND OF THE INVENTION

Field of the Invention

The present invention relates to a circuit for testability on a logic circuit or the like to be packaged on a system LSI, and particularly to composition of scan paths for serial scanning.

Description of the Prior Art

Recently, a logic circuit which is packaged on a system LSI becomes large in scale, thus the length of a testing time of the circuit becomes one of problems in manufacture thereof. As an effective method of testing the logic circuit, for example, a parallel scan method and a serial scan method are known. Of these, in the parallel scan method, it is possible to designate addresses of any given registers which are objects of the test in the logic circuit. Accordingly, the method can effectively carry out various tests in the case. However, it requires a lot of circuit elements only for the test, and the whole scale of the system becomes unnecessarily large.

While, in the serial scan method, addresses of a serial group of registers are designated so that reading and writing on each of the register groups are conducted. Namely, since the address designation is conducted corresponding to each the register group, the method requires relatively few circuit elements for the address designation as compared with the parallel scan method. However, in this case, the whole bodies of the register groups whose addresses are to be designated should be scanned even if it is unnecessary, thus it takes so much time.

As a countermeasure against the problems, there are a method in which a plurality of scan paths are scanned at the same time by internal buses, and a method in which scan paths are provided in respective functional blocks in the logic circuit so that tests on the functional blocks are independently carried out.

The last method in the above describe, that is, the method in which scan paths are provided in the respective functional blocks, is superior in that the functional blocks can be tested independently. However, when the mutual relations among the respective functional blocks are tested as a combinational circuit in which are arranged input and output portions of the functional blocks, dummy test data should be set even in register groups other than those which are objects of the tests on the functional blocks. Accordingly, the test requires so much time. Such a testing circuit is known from US-A-4.698.588.

SUMMARY OF THE INVENTION

It is therefore an object of the present invention to provide a circuit for testability which can efficiently carry out tests on respective functional blocks and a combinational circuit defined among the respective functional blocks.

The object of the invention is solved by a circuit for testability to be provided in a logic circuit composed of a plurality of functional blocks, comprising: a plurality of register groups obtained by division of a plurality of registers included in the functional blocks, one portion of the register groups being composed of registers other than those related to the input and output of the functional blocks; scan paths for scanning the register groups so as to carry out input and output of storage contents of the register groups respectively corresponding thereto, each of the scan paths being connected to a common bus of the logic circuit and carrying out the input and output of the test data through the common bus, and control means for designating addresses of the scan paths and controlling input and output of test signals for the register groups respectively corresponding to the scan paths, characterised in that another portion of the plurality of the register groups included in the functional blocks is composed of registers only related to input and output of the functional blocks, and in that the plurality of the register groups included in the functional blocks are respectively connected to different signal lines of the common bus.

According to the above-mentioned composition in the circuit for testability of the present invention, only addresses of the scan paths to be connected to the register groups related to the input and output can be carried out when the tests on the combinational circuit defined among the respective functional blocks are conducted. Thus, the tests can be efficiently carried out.

These and other objects, features and advantages of the present invention will be more apparent from the following description of preferred embodiments, taken in conjunction with the accompanying drawings.

## BRIEF DESCRIPTION OF THE DRAWING

Fig. 1 is a schematical block diagram of a system LSI having a circuit for testability according to the present invention;

Fig. 2 is a block diagram of a logic circuit having a circuit for testability, which is an embodiment according to the present invention; and

Fig. 3 is a block diagram of a logic circuit having a circuit for testability, which is another embodiment of the present invention.

## DETAILED DESCRIPTION OF THE EMBODIMENT

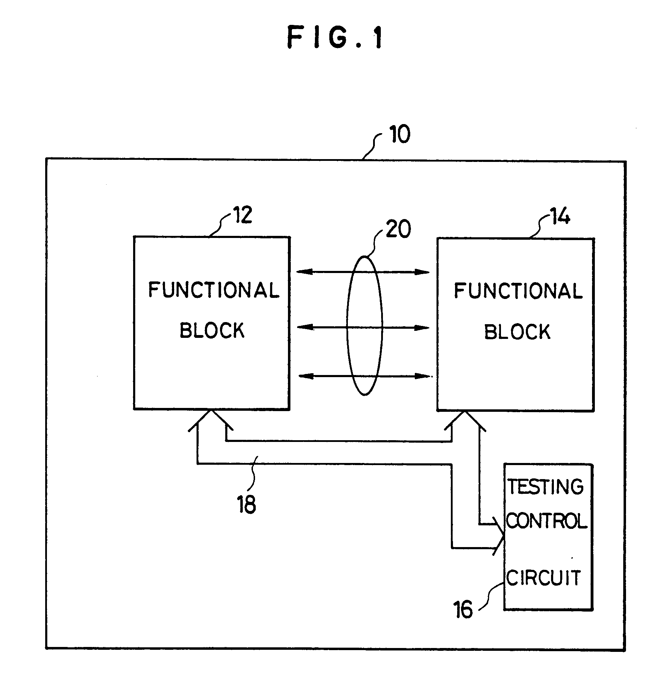

Hereinafter, embodiments of the present invention will be described with reference to Figs. 1, 2 and 3.

Fig. 1 is a schematical block diagram of a system LSI having a circuit for testability according to the present invention.

In the diagram, reference numerals 12 and 14 respectively designate functional blocks including a combinational circuit, a group of storage means and the like. Moreover, 16 indicates a testing control circuit, and 18 shows a common bus for connecting the functional blocks 12, 14 and the testing control circuit 16, further 20 shows an internal bus which is used for input and output of data transmitted between the functional blocks 12 and 14. The above-mentioned functional blocks 12 and 14, testing control circuit 16, common bus 18 and internal bus are all incorporated in a one-chip LSI.

In LSI 10 having composition as stated above, operational tests on the functional blocks 12 and 14 are carried out under control of the testing control circuit 16.

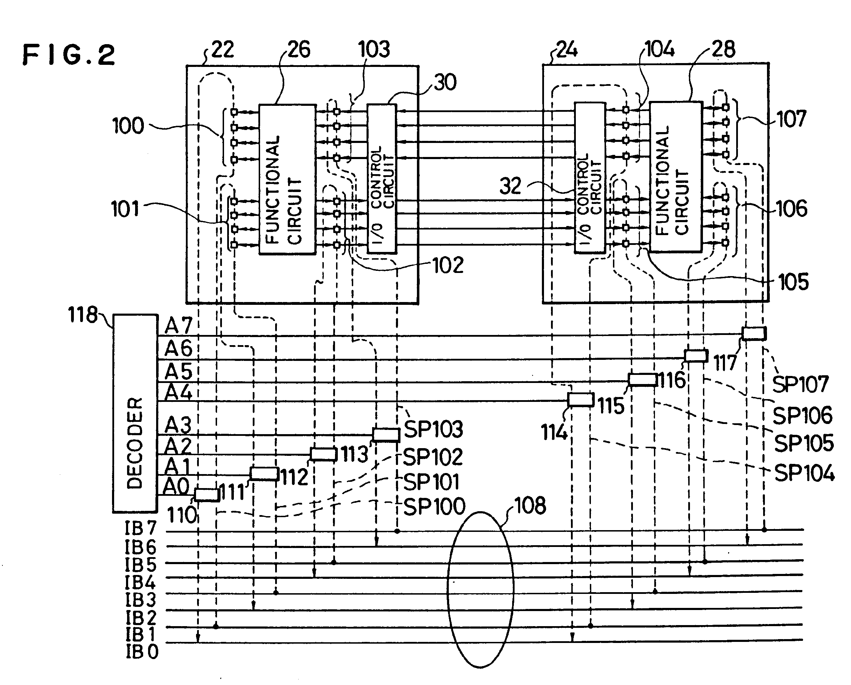

Fig. 2 is a block diagram of a logic circuit having a circuit for testability, which is an embodiment of the present invention. In the same diagram is shown a circuit for testability of a logic circuit, which is mainly composed of functional blocks 22 and 24. The functional blocks 22 and 24 respectively and mainly comprise functional circuit 26 and 28 for effecting processes corresponding to the respective functions thereof, and input-output (I/O) control circuits 30 and 32 for controlling input and output between the functional blocks 22 and 24. While, register groups 100, 101, 102, 103, 104, 105, 106 and 107 in the embodiment respectively comprise four registers, for example flip-flops (F/F), as storage means. Moreover, these register groups 100 - 107 are respectively connected to scan paths SP100, SP101, SP102, SP103, SP104, SP105, SP106 and SP107. While the four F/F which compose each the register group are connected in series to the scan paths. Additionally, switch elements 110, 111, 112, 113, 114, 115, 116 and 117 are provided as selecting means for the respective scan paths. These switch elements are selected and driven through signal lines of the address bus A0 - A7 by a decoder 118 which is one of control means. In such a manner, the decoder 118 outputs control signals for designating register groups to be objects in the tests. Therefore the switch elements become active or inactive states.

Incidentally, the registers in the embodiment are divided into groups based on predetermined functions thereof. For example, the registers are classified into registers belonging to functional circuits, ones belonging to output control circuits and others to input control circuits, and one register group is formed with registers of the same function. In connection of the respective scan paths SP100 - SP107 and the common bus 108, the scan paths SP100 - SP107 are connected different bus lines IB0 - IB7 respectively. Namely, in this case, scan paths which can be selected and operated at the same time are connected to different bus lines as explained in more detail hereinafter.

The register group 100 is connected to the bus lines IB0 and IB1 through the scan path SP100,

101 is connected to IB2 and IB3 through SP101,

102 is connected to IB4 and IB5 through SP102,

103 is connected to IB6 and IB7 through SP103,

104 is connected to IB0 and IB1 through SP104,

105 is connected to IB2 and IB3 through SP105,

106 is connected to IB4 and IB5 through SP106, and

107 is connected to IB6 and IB7 through SP107.

Next, explanations on operation of the circuit for testability in this embodiment having the above-mentioned composition will be given.

When the functional circuits 26 and 28 are independently tested, the decoder 118 generates and transmits control signals to the switch elements 110 - 117. Then through scan paths to be selected by the signals, input and output of data to the register groups belonging to the selected scan paths are conducted. For example, when the scan path SP100 is selected, the four registers composing the register group 100 become objects in the test.

3

Next, explanations on tests among the respective blocks will be given.

In this case, the switch elements 112, 113, 114 and 115 are selected by the decoder 118. Therefore, the selected switch elements become active. Namely, test data are inputted into the register groups 104 and 102 through the signal lines of the common bus IB0, IB1, IB4, and IB5 (which will be omitted as common bus lines hereinafter) so as to determine test conditions of the I/O control circuits 30 and 32. With respect to the operational results of the I/O control circuits 30 and 32, the data are outputted through the common bus lines IB2, IB3, IB6 and IB7 by scan of the register groups 105 and 103.

Time $T_{t1}$ required for the test between the functional blocks is obtained in the following manner. When the longer one of scan times in the scan paths SP102 and SP104 is L1, and the longer one of scan times in the scan paths SP103 and SP105 is L2, the time $T_{t1}$ to be required for the test can be approximately shown by the following equation:

$$T_{t1} \fallingdotseq (L1 + L2) \times T_c$$

where $T_c$ is a time required for the scan of each the register (flip-flop).

Table 1 shows relations of the input and output of the test data in the respective register groups on the operation of this embodiment as described above. In the table, numeral 1 in the row of Input means input of the test data to each the corresponding register group, and numeral 1 in the row of Output means output of the operational results from each the register group to the internal bus 108 through the corresponding switch elements. While, numeral 0 in the table means that neither input nor output was conducted.

As apparently shown in the table, since only register groups 102, 103, 104 and 105 have to be operated on the combinational tests between the I/O control circuits 30 and 32, the tests can be conducted with great efficiency.

## TABLE 1

| | REGISTER GROUP | 100 | 101 | 102 | 103 | 104 | 105 | 106 | 107 |
|---|---|---|---|---|---|---|---|---|---|
| TEST OF FUNCTIONAL BLOCK 22 | INPUT | 1 | 1 | 1 | 1 | 0 | 0 | 0 | 0 |
| | OUTPUT | 1 | 1 | 1 | 1 | 0 | 0 | 0 | 0 |
| TEST OF FUNCTIONAL BLOCK 24 | INPUT | 0 | 0 | 0 | 0 | 1 | 1 | 1 | 1 |
| | OUTPUT | 0 | 0 | 0 | 0 | 1 | 1 | 1 | 1 |
| TEST BETWEEN I/O CONTROL CIRCUITS 30 AND 32 | INPUT | 0 | 0 | 1 | 1 | 1 | 1 | 0 | 0 |
| | OUTPUT | 0 | 0 | 1 | 1 | 1 | 1 | 0 | 0 |

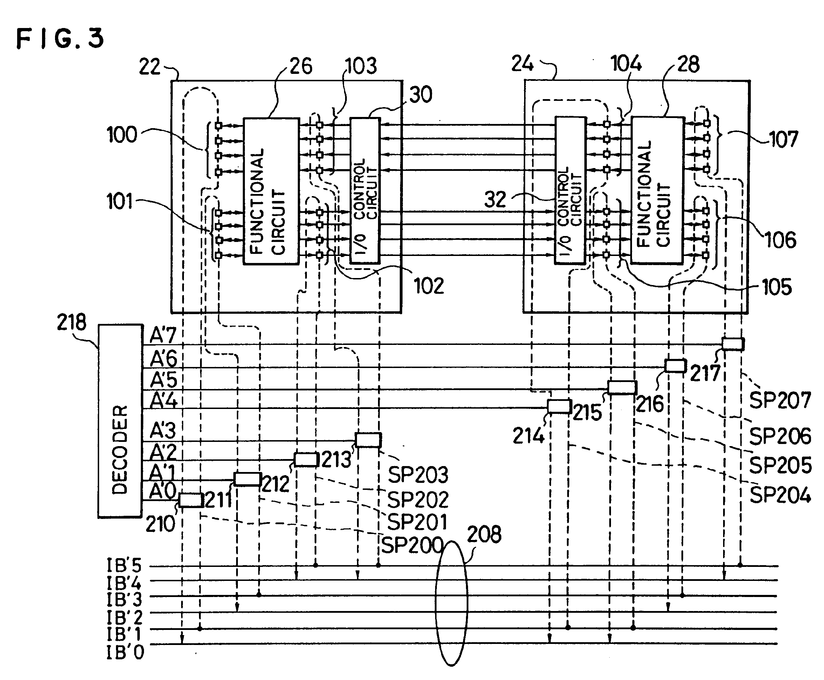

Fig. 3 is a compositional diagram of a logic circuit including a circuit for testability, which is another embodiment of the present invention. In the diagram, reference characters SP200, SP201, SP202, SP203, SP204, SP205, SP206 and SP207 designate scan paths respectively corresponding to register groups 100 - 107. In the respective scan paths SP200 - SP207 are provided switch elements 210 - 217 which are selected and driven by a decoder 218. The driving manner in this case is the same as described in the first embodiment. Reference numeral 208 indicates a common bus which comprises six bus lines IB'0, IB'1, IB'2, IB'3, IB'4 and IB'5.

Moreover, in the drawing, the register group 100 is connected to the bus lines IB'0 and IB'1 through the scan path SP200,

101 is connected to IB'2 and IB'3 through SP201,
102 is connected to IB'4 and IB'5 through SP202,
103 is connected to IB'4 and IB'5 through SP203,
104 is connected to IB'0 and IB'1 through SP204,
105 is connected to IB'0 and IB'1 through SP205,
106 is connected to IB'2 and IB'3 through SP206, and
107 is connected to IB'4 and IB'5 through SP207.

In the circuit for testability of this embodiment, when the functional circuits 26, 28 and the combinational circuit to be formed between the I/O control circuits 30 and 32 are tested independently, scan-out of the registers which are used for input is not carried out at a time of input of test data. Namely, scan out of the registers relating to input is not conducted. To the contrary, scan-in of the registers which are used for output is not carried out at a time of output of the test data. Accordingly, the scan paths SP202 and SP203 respectively connected to the register groups 102 and 103 can be connected to the same bus lines IB'4 and IB'5. Namely, when the functional circuit 26 is tested, test data are inputted into the register group 103 through the scan path SP203 from the bus line IB'5. While, contents of the register group 102 are outputted to the bus line IB'4 through the switch elements 212. Moreover, when the I/O control circuit 30 is tested, test data are inputted into the register group 102 through the scan path SP202 from the bus line IB'5. While, contents of the register group 103 are outputted to the bus line IB'4 through the switch elements 213. Similarly, the scan paths SP204 and SP205 respectively connected to the register groups 104 and 105 can be connected to the same address buses IB'0 and IB1. Accordingly, the common bus 208 which should be required in the embodiment can be composed of the six address buses, so that the size of a system LSI to be composed therewith can be reduced so much.

Table 2 shows relations between input and output of the test data in the respective register groups 100 - 107 of the circuit for testability of this embodiment. In the table, numeral 1 means that either input or output of the test data was carried out, while numeral 0 means that neither input nor output was carried out.

As apparently shown in the table, the circuit for testability according to the embodiment can perform combinational tests (of the I/O control circuit 30 and 32) between the functional blocks 22 and 24 using only the register groups 102, 103, 104 and 105.

Accordingly, it is not necessary to set dummy test data in the register groups 100, 101, 106 and 107 which are not directly related to the tests.

## TABLE 2

| | REGISTER GROUP | 100 | 101 | 102 | 103 | 104 | 105 | 106 | 107 |
|---|---|---|---|---|---|---|---|---|---|
| TEST OF FUNCTIONAL BLOCK 22 | INPUT | 1 | 1 | 0 | 1 | 0 | 0 | 0 | 0 |
| | OUTPUT | 1 | 1 | 1 | 0 | 0 | 0 | 0 | 0 |
| TEST OF FUNCTIONAL BLOCK 24 | INPUT | 0 | 0 | 0 | 0 | 0 | 1 | 1 | 1 |
| | OUTPUT | 0 | 0 | 0 | 0 | 1 | 0 | 1 | 1 |
| TEST BETWEEN I/O CONTROL CIRCUITS 30 AND 32 | INPUT | 0 | 0 | 1 | 0 | 1 | 0 | 0 | 0 |
| | OUTPUT | 0 | 0 | 0 | 1 | 0 | 1 | 0 | 0 |

In the above embodiments, the register groups 100, 101, 102, 103, 104, 105, 106 and 107 are respectively composed of four registers (F/F), however, the respective numbers of the registers (F/F) in these register groups may be different from one another.

Generally, in a logic circuit, the number of registers (F/F) composing each register group differs per register group.

Accordingly, in case of an ordinary circuit for testability for which is required setting test data (including dummy data) in the whole body of register groups in functional blocks, and when the number of registers belonging to register groups which do not contribute to the tests is larger than that of registers in register groups which contribute to the tests, time $T_t$ required for the tests can be expressed by the following equation:

$$T_t \doteqdot 2 \times L_3 \times T_c$$

where $L_1$ is the number of registers in a register group requiring a longest time to be scanned in register groups to which the test data are inputted, $L_2$ is the number of registers in a register group requiring a longest time to be scanned in register groups from which results of the tests are outputted, $L_3$ is the number of registers which do not contribute to the tests, and these $L_1$, $L_2$ and $L_3$ satisfy

$$L_3 > L_1 \text{ and } L_3 > L_2 .$$

Moreover, in the above equation, coefficient 2 shows that these $L_3$ pieces of registers are scanned twice so as to input the test data first and then output the result data from these functional circuits.

While, since the following equation:

$$2 \times L_3 > (L_1 + L_2)$$

can be established, the relation between $T_t$ and the above mentioned time $T_{t1}$ which is required for the tests between the functional blocks can be expressed by the following equation:

$$T_t > T_{t1} .$$

Accordingly, the time required for the tests becomes inefficiently long when the number of registers in the register groups becomes large.

To the contrary, in the circuit for testability according to the embodiment, since it is possible to set the test data only in the register groups which contribute to the tests, the efficiency on test can be much improved.

Reference signs in the claims are intended for better understanding and shall not limit the scope.

## Claims

1. A circuit for testability to be provided in a logic circuit composed of a plurality of functional blocks, comprising:

    a plurality of register groups (100 to 107) obtained by division of a plurality of registers included in the functional blocks (22, 24), one portion of the register groups (100 to 107) being composed of registers other than those related to the input and output of the functional blocks (22, 24);

    scan paths (SP100 to SP107) for scanning the register groups (100 to 107) so as to carry out input and output of storage contents of the register groups (100 to 107) respectively corresponding thereto, each of the scan paths (SP100 to SP107) being connected to a common bus (108) of the logic circuit and carrying out the input and output of the test data through the common bus (108), and

    control means (118) for designating addresses of the scan paths (SP100 to SP107) and controlling input and output of test signals for the register groups (100 to 107) respectively corresponding to the scan paths (SP100 to SP107),

    **characterised** in that

    another portion of the plurality of the register groups (100 to 107) included in the functional blocks (22, 24) is composed of registers only related to input and output of the functional blocks (22, 24), and in that the plurality of the register groups (100 to 107) included in the functional blocks (22, 24) are respectively connected to different signal lines of the common bus (108).

2. A circuit for testability according to claim 1,

    **characterised** in that

    switch means (110 to 117) is provided to each of the scan paths (SP100 to SP107), each the switch means (110 to 107) is connected to the controlling means (118), and selection of each the scan paths (SP100 to SP107) is carried out by each the switch means (110 to 107).

3. A circuit for testability according to claim 1,

    **characterised** in that

    both of the register groups (100 to 107) related to the input and those related to the output are connected to the same signal lines (IB'0, IB'1) in the common bus (208).

4. A circuit for testability according to claim 1, further
**characterised** by:
first scan paths for effecting input and output of storage contents of one portion of the register groups belonging to the circuit portion related to the input and output;
second scan paths for effecting input and output of storage contents of the other portion of the register groups belonging to the circuit portion related to the functions other than the input and output; and
the first and the second scan paths are respectively and independently provided.

5. A circuit for testability according to claim 4,
**characterised** in that
the first scan paths further comprise scan paths related to input and thos related to output respectively.

6. A circuit for testability according to claim 4,
**characterised** in that
the register groups (100 to 107) comprise shift registers respectively.


**Patentansprüche**

1. Prüfbarkeitsschaltung zum Vorsehen in einer logischen Schaltung, die aus einer Vielzahl von Funktionsblöcken zusammengesetzt ist, aufweisend:
   - eine Vielzahl von Registergruppen (100 bis 107), die durch Teilen einer Vielzahl von Registern in den Funktionsblöcken (22, 24) erhalten werden, wobei ein Teil der Registergruppen (100 bis 107) aus anderen Registern als jenen zusammengesetzt ist, die sich auf die Eingabe und Ausgabe von Funktionsblöcken (22, 24) beziehen;
   - Abtastpfade (SP100 bis SP107) zum Abtasten der Registergruppen (100 bis 107), so, daß die Eingabe und Ausgabe von Speicherinhalten der diesen jeweils entsprechenden Registergruppen (100 bis 107) durchgeführt wird, wobei die Abtastpfade (SP100 bis SP107) an einen Sammelbus (108) der logischen Schaltung angeschlossen sind und die Eingabe und Ausgabe der Testdaten durch den Sammelbus (108) durchführen; und
   - Steuereinrichtungen (118) zum Bezeichnen der Adressen der Abtastpfade (SP100 bis SP107) und zum Steuern der Eingabe und Ausgabe der Testsignale für die Registergruppen (100 bis 107), die jeweils entsprechend den Abtastpfaden (SP100 bis SP107) zugeordnet sind; dadurch
   **gekennzeichnet** , daß
   - ein anderer Teil der Vielzahl der in den Funktionsblöcken (22, 24) enthaltenen Registergruppen (100 bis 107) aus Registern besteht, die sich nur auf die Eingabe und Ausgabe der Funktionsblöcke (22, 24) beziehen, und daß die Vielzahl der in den Funktionsblöcken (22, 24) enthaltenen Registergruppen (100 bis 107) jeweils entsprechend an unterschiedliche Signalleitungen des Sammelbusses (108) angeschlossen sind.

2. Prüfbarkeitsschaltung nach Anspruch 1,
dadurch **gekennzeichnet,** daß Schalteinrichtungen (110 bis 117) für jeden der Abtastpfade (SP100 bis SP107) vorgesehen sind, wobei jede Schalteinrichtung (110 bis 107) an die Steuereinrichtung (118) angeschlossen ist, und die Wahl jedes der Abtastpfade (SP100 bis SP107) durch jede der Schalteinrichtungen (110 bis 107) durchgeführt wird.

3. Prüfbarkeitsschaltung nach Anspruch 1,
dadurch **gekennzeichnet**, daß sowohl die Registergruppen (100 bis 107), die sich auf die Eingabe beziehen, als auch jene Gruppen, die sich auf die Ausgabe beziehen, im Sammelbus (208) an die gleichen Signalleitungen (IB'0, IB'1) angeschlossen sind.

4. Prüfbarkeitsschaltung nach Anspruch 1,
weiter **gekennzeichnet** durch:
   - erste Abtastpfade zur Durchführung der Eingabe und Ausgabe der Speicherinhalte eines Teils der Registergruppen, die zu dem auf die Eingabe und Ausgabe bezogenen Schaltungsteil gehören;
   - zweite Abtastpfade zur Durchführung der Eingabe und Ausgabe von Speicherinhalten des anderen Teils der Registergruppen, die zu dem Schaltungsteil gehören, der sich auf andere Funktionen als die Eingabe und Ausgabe bezieht; und

- wobei die ersten und die zweiten Abtastpfade jeweils und unabhängig voneinander vorgehen sind.

5. Prüfbarkeitsschaltung nach Anspruch 4,
dadurch **gekennzeichnet**, daß die ersten Abtastpfade weiter Abtastpfade aufweisen, die sich jeweils entsprechend auf die Eingabe und auf die Ausgabe beziehen.

6. Prüfbarkeitsschaltung nach Anspruch 4,
dadurch **gekennzeichnet**, daß die Registergruppen (100 bis 107) jeweils Schieberegister umfassen.

**Revendications**

1. Circuit pour l'aptitude au test à fournir dans un circuit logique constitué d'une multitude de blocs fonctionnels, comprenant :
une multitude de groupes de registres (100 à 107) obtenue par la division d'une multitude de registres inclus dans les blocs fonctionnels (22, 24), une portion des groupes de registres (100 à 107) étant composée de registres autres que ceux concernant l'entrée et la sortie des blocs fonctionnels (22, 24);
des trajets de balayage (SP100 à SP107) pour balayer les groupes de registres (100 à 107) de manière à exécuter l'entrée et la sortie des contenus emmagasinés des groupes de registres (100 à 107) leur correspondant respectivement, chacun des trajets de balayage (SP100 à SP107) étant connecté à un bus commun (108) du circuit logique et exécutant l'entrée et la sortie des données de test par l'intermédiaire du bus commun (108), et
un moyen de commande (118) pour désigner des adresses des trajets de balayage (SP100 à SP107) et commander l'entrée et la sortie des signaux de test pour les groupes de registres (100 à 107) correspondant respectivement aux trajets de balayage (SP100 à SP107),
caractérisé en ce que :
une autre portion de la multitude des groupes de registres (100 à 107) inclus dans les blocs fonctionnels (22, 24) est constituée de registres ne concernant que l'entrée et la sortie des groupes fonctionnels (22, 24), et en ce que
la multitude des groupes de registres (100 à 107) inclus dans les blocs fonctionnels (22, 24) est connectée respectivement à des lignes de signaux différentes du bus commun (108).

2. Circuit pour l'aptitude au test selon la revendication 1,
caractérisé en ce que
des moyens de commutateur (110 à 117) sont fournis pour chacun des trajets de balayage (SP100 à SP107), chaque moyen de commutateur (110 à 107) est connecté au moyen de commande (118), et la sélection de chacun des trajets de balayage (SP100 à SP107) est exécutée par chaque moyen de commutateur (110 à 107).

3. Circuit pour l'aptitude au test selon la revendication 1,
caractérisé en ce que les groupes de registres (100 à 107) concernant l'entrée et ceux relatifs à la sortie sont connectés aux mêmes lignes de signal (IB'0, IB'1) dans le bus commun (208).

4. Circuit pour l'aptitude au test selon la revendication 1, caractérisé en outre par :
des premiers trajets de balayage pour effectuer l'entrée et la sortie des contenus emmagasinés d'une portion des groupes de registres appartenant à la portion du circuit concernant l'entrée et la sortie;
des seconds trajets de balayage pour effectuer l'entrée et la sortie des contenus emmagasinés de l'autre portion des groupes de registres appartenant à la portion de circuit concernant les fonctions autres que l'entrée et la sortie; et
les premier et second trajets de balayage sont respectivement et indépendamment fournis.

5. Circuit pour l'aptitude au test selon la revendication 4,
caractérisé en ce que les premiers trajets de balayage comprennent en outre des trajets de balayage concernant l'entrée et ceux relatifs à la sortie, respectivement.

6. Circuit pour l'aptitude au test selon la revendication 4,
caractérisé en ce que les groupes de registres (100 à 107) comprennent des registres à décalage, respectivement.

# F I G . 1

F I G. 2

EP 0 382 184 B1

F I G. 3